# EUROPEAN PATENT SPECIFICATION

(11) **EP 2 333 857 B1**
(45) Date of publication and mention of the grant of the patent: **12.11.2014**
(21) Application number: 09802912.7
(22) Date of filing: 27.07.2009
(51) Int. Cl.: H01L 41/083, H01L 41/273, H01L 41/337, F02M 51/06

(54) **STACKED PIEZOELECTRIC ELEMENT, METHOD FOR MANUFACTURING STACKED PIEZOELECTRIC ELEMENT, JET DEVICE AND FUEL JET SYSTEM**
GESTAPELTES PIEZOELEKTRISCHES ELEMENT, VERFAHREN ZUR HERSTELLUNG EINES GESTAPELTEN PIEZOELEKTRISCHEN ELEMENTS, EINSPRITZEINRICHTUNG UND KRAFTSTOFFEINSPRITZSYSTEM
ÉLÉMENT PIÉZOÉLECTRIQUE EMPILÉ, PROCÉDÉ DE FABRICATION D'UN ÉLÉMENT PIÉZOÉLECTRIQUE EMPILÉ, DISPOSITIF DE JET ET SYSTÈME DE JET DE COMBUSTIBLE

(30) Priority: 29.07.2008 JP 2008194595
(43) Date of publication of application: 15.06.2011
(73) Proprietor: Kyocera Corporation, Kyoto-shi Kyoto 612-8501 (JP)
(72) Inventor: SATA, Tetsurou, Kirishima-shi Kagoshima 899-4396 (JP)
(74) Representative: Beetz & Partner
(86) International application number: PCT/JP2009/063340
(87) International publication number: WO 2010/013669

(56) References cited:
- EP-A2- 1 453 114
- DE-A1-102004 018 100
- JP-A- 2001 339 105
- JP-A- 2002 370 217
- JP-A- 2003 017 779
- US-A- 5 252 883

## Description

### Technical Field

The present invention relates to a multi-layer piezoelectric element using a stacked body in which piezoelectric layers and internal electrode layers are alternately laminated, a method for manufacturing a multi-layer piezoelectric element, an injection device, and a fuel injection system. A multi-layer piezoelectric element as described in the preamble portion of patent claim 1 has been known from DE 10 2004 018 100 A1.

### Background Art

A multi-layer piezoelectric element (hereinafter simply referred to as an "element") including a stacked body in which a plurality of piezoelectric layers are laminated with internal electrode layers interposed therebetween, and having a pair of external electrodes formed on side faces of the stacked body has conventionally been known. This element is generally constituted by flat portions, and ridge portions (edge portions) joining adjacent flat portions together in the circumferential direction. When a voltage is applied to the element from the external electrodes, adjacent internal electrode layers are apt to be short-circuited in the edge portions.

This is caused by the fact that, when the surface of the stacked body is ground in order to shape the stacked body in shapes such as a prismatic shape, a linear grinding trace is formed on the surface of the stacked body, and the linear grinding trace is apt to be formed across adjacent internal electrode layers on the edge portions. That is, it is considered that, when the multi-layer piezoelectric element is driven, the linear grinding trace formed over the adjacent internal electrode layers grows as a crack due to stress, and the adjacent internal electrode layers are short-circuited by creeping discharge through the crack or as conductor components of the internal electrode layers are moved by diffusion or the like through the crack.

Thus, an element is disclosed in which stress generated near edge portions is reduced by chamfering a stacked body so that the edge portions have a C or R face (see JP 2006-120579 A).

DE 10 2004 018 100 A discloses a multi-layer piezoelectric element comprising a prismatic stacked body in which piezoelectric layers and internal electrode layers are alternately laminated, wherein the stacked body comprises a chamfered portion formed by grinding a ridge portion of a side peripheral surface thereof.

The internal electrode layer comprises a blank portion formed in a circumference thereof, the blank portion being a portion where the internal electrode layer withdraws from a side peripheral surface of the stacked body, and the stacked body comprises a chamfered portion formed by grinding a ridge portion of the side peripheral surface thereof.

US 5 252 883 A relates to a laminated type piezoelectric actuator comprising a prismatic stacked body in which piezoelectric layers and internal electrode layers are alternately laminated. The stacked body comprises a chamfered portion formed by grinding a ridge portion of a side peripheral surface thereof.

EP 1 453 114 A2 relates to a laminated electronic actuator comprising a prismatic stacked body in which piezoelectric layers and internal electrode layers are alternately laminated. A side peripheral surface of the stacked body is ground in a direction in parallel with the internal electrodes.

### Disclosure of Invention

### Technical Problem

However, in recent years, an element which can be continuously driven for a prolonged period of time under a high voltage and high pressure is required, and further improvements in durability are desired for this element. That is, there is a problem in that it is difficult to sufficiently suppress short-circuiting between adjacent internal electrode layers only by performing chamfering processing on the stacked body so that the edge portions have a C or R face as described in JP 2006-120579 A.

The invention has been completed in view of the problems in the related art mentioned above, and the objects thereof are to provide a multi-layer piezoelectric element with improved durability by effectively suppressing short-circuiting between adjacent internal electrode layers in edge portions of a stacked body, and to provide a method for manufacturing the multi-layer piezoelectric element, and an injection device and a fuel injection system using the multi-layer piezoelectric element.

### Solution to Problem

These objects are accomplished with a multi-layer piezoelectric element, a method for manufacturing such multi-layer piezoelectric element, an injection device and a fuel injection system as claimed in claims 1, 3, 6 and 7, respectively.

The invention provides a multi-layer piezoelectric element comprising a prismatic stacked body in which piezoelectric layers and internal electrode layers are alternately laminated, wherein the stacked body comprises a chamfered portion formed by grinding a ridge portion of a side peripheral surface thereof, and a linear grinding trace on the chamfered portion extends in a direction along the internal electrode layers, the stacked body is formed so that the linear grinding trace extends in the direction along the internal electrode layers from the chamfered portion to a flat face of a side peripheral surface adjacent thereto.

Furthermore, in the invention, it is preferable that a surface roughness of the chamfered portion and a surface roughness of the flat face of the side peripheral surface in the stacked body are equal to each other

The invention provides a method for manufacturing a multi-layer piezoelectric element which comprises a prismatic stacked body in which piezoelectric layers and internal electrode layers are alternately laminated, the method comprising grinding a side peripheral surface of the stacked body by a grinding tool while rotating the stacked body around a longitudinal axis thereof with holding both ends of the stacked body.

Furthermore, in the invention, it is preferable that the grinding tool is installed to be capable of advancing and retreating with respect to the side peripheral surface of the stacked body rotated, so as to grind an entire periphery of the side peripheral surface of the stacked body.

Furthermore, in the invention, it is preferable that both end faces of the stacked body are held by applying pressure with a pressing force of 10 MPa or more and 100 MPa or less using a holding tool of which a Vickers hardness Hv is 20 or more and 100 or less.

The invention provides an injection device comprising a container comprising an injection nozzle, and any one of the multi-layer piezoelectric elements mentioned above, wherein a liquid stored in the container is configured to be injected through the injection nozzle by driving the multi-layer piezoelectric element.

The invention provides a fuel injection system comprising a common rail configured to store high-pressure fuel, the injection device mentioned above configured to inject the high-pressure fuel stored in the common rail, a pressure pump configured to supply the high-pressure fuel to the common rail, and an injection control unit configured to send a driving signal to the injection device.

### Advantageous Effects of Invention

According to the multi-layer piezoelectric element of the invention, there is provided a multi-layer piezoelectric element comprising a prismatic stacked body in which piezoelectric layers and internal electrode layers are alternately laminated, wherein the stacked body comprises a chamfered portion formed by grinding a ridge portion of a side peripheral surface thereof, and a linear grinding trace on the chamfered portions extends in a direction along the internal electrode layers. Therefore, since the linear grinding trace is formed along the internal electrode layers on the ridge portion (edge portion) of the prismatic stacked body, even if cracks generated due to stress along the linear grinding trace grow by continuous drive of the multi-layer piezoelectric element, the cracks do not join adjacent internal electrode layers together. As a result, since short-circuiting between adjacent internal electrode layers in the edge portion can be effectively suppressed, durability can be improved.

Additionally, according to the multi-layer piezoelectric element of the invention, when the stacked body is formed so that the linear grinding trace extends in the direction along the internal electrode layers from the chamfered portion to the flat face of the side peripheral surface adjacent thereto, short-circuiting between adjacent internal electrode layers can be effectively suppressed even in the flat face as well as the edge portion of the stacked body, and thereby, durability can be further improved.

Additionally, according to the multi-layer piezoelectric element of the invention, when a surface roughness of the chamfered portions and a surface roughness of the flat face of the side peripheral surface in the stacked body are equal to each other, the surface roughnesses of the portions of the internal electrode layers which are exposed to the side peripheral surface of the stacked body become almost the same on any portion of the side peripheral surface of the stacked body, and concentration of a local electric field in the internal electrode layers is eliminated. Thus, it is possible to suppress concentration of stress on some of the internal electrode layers. As a result, short-circuiting between adjacent internal electrode layers can be effectively suppressed in any portion of the side peripheral surface of the stacked body, and durability can be further improved.

According to the method for manufacturing a multi-layer piezoelectric element of the invention, there is provided a method for manufacturing a multi-layer piezoelectric element which comprises a prismatic stacked body in which piezoelectric layers and internal electrode layers are alternately laminated. The method comprises grinding a side peripheral surface of the stacked body by a grinding tool while rotating the stacked body around a longitudinal axis thereof with holding both ends of the stacked body. Therefore, the linear grinding trace extending in the direction along the internal electrode layers can be formed on the side peripheral surface of the stacked body. As a result, since short-circuiting between the adjacent internal electrode layers in the edge portion of the stacked body can be effectively suppressed, and the multi-layer piezoelectric element with improved durability can be manufactured.

Additionally, according to the method for manufacturing a multi-layer piezoelectric element of the invention, when the grinding tool is installed to be capable of advancing and retreating with respect to the side peripheral surface of the stacked body rotated, so as to grind an entire periphery of the side peripheral surface of the stacked body, the linear grinding trace extending in the direction along the internal electrode layers can be formed with almost the same depth, in any portion of the side peripheral surface of the stacked body. As a result, since short-circuiting between the adjacent internal electrode layers in the side peripheral surface of the stacked body can be effectively suppressed, and the multi-layer piezoelectric element with further improved durability can be manufactured.

Additionally, according to the method for manufacturing a multi-layer piezoelectric element of the invention, when both end faces of the stacked body are held by applying pressure with a pressing force of 10 MPa or more and 100 MPa or less using a holding tool of which a Vickers hardness Hv is 20 or more and 100 or less, the Vickers hardness Hv of the holding tool is not too high. Therefore, when the holding tool holds the stacked body, the contact surfaces of the holding tool with both end faces of the stacked body are pressed against the stacked body, and thereby deformed so as to fit both end faces of the stacked body. Accordingly, since a large frictional force is generated between the holding tool and both end faces of the stacked body compared to a case where the Vickers hardness Hv of the holding tool is too high, the stacked body can be held by the holding tool by a larger force. Accordingly, it is possible to suppress reduction of grinding precision due to deviation of the stacked body from the holding tool during grinding.

Additionally, since the stacked body is held by applying pressure with a pressing force of 10 MPa or more and 100 MPa or less, the stacked body contracts in the longitudinal direction during grinding processing, and it is possible to suppress deformation of the stacked body in a direction orthogonal to the longitudinal direction. Accordingly, in a case where grinding resistance, the pressure caused by a grinding liquid, or the like has acted on the stacked body from a direction in which the grinding stone is present, it is possible to suppress deformation of the stacked body in a direction in which the stacked body escapes from the grinding stone among directions orthogonal to the longitudinal direction. Accordingly, it is possible to suppress non-uniform grinding between the central portion of the stacked body deforming in a direction in which the stacked body escapes from the grinding stone, and both ends of the stacked body which do not deform. As a result, the side faces of the stacked body can be equally ground without being biased to a certain portion.

The injection device of the invention comprises a container comprising an injection nozzle, and the multi-layer piezoelectric element of the invention, wherein a liquid stored in the container is configured to be injected through the injection nozzle by driving the multi-layer piezoelectric element. Therefore, since the multi-layer piezoelectric element of the invention having excellent durability is used, an injection device having excellent durability is provided.

The fuel injection system of the invention comprises a common rail configured to store high-pressure fuel, the injection device of the above invention configured to inject the high-pressure fuel stored in the common rail, a pressure pump configured to supply the high-pressure fuel to the common rail, and an injection control unit configured to send a driving signal to the injection device. Therefore, since the injection device using the multi-layer piezoelectric element of the invention having excellent durability is used, a fuel injection system having excellent durability is provided.

### Brief Description of Drawings

Fig. 1 is a side view showing a multi-layer piezoelectric element according to an embodiment of the invention;
Fig. 2 is a perspective view of the multi-layer piezoelectric element shown in Fig. 1;
Fig. 3 is a schematic side view showing a grinding step in a method for manufacturing the multi-layer piezoelectric element according to an embodiment of the invention;
Fig. 4(a) is a schematic plan view showing a grinding step in a method for manufacturing a multi-layer piezoelectric element according to another embodiment of the invention, and Figs. 4(b) to 4(d) are similarly schematic longitudinal cross-sectional views showing the grinding step;
Fig. 5 is a schematic cross-sectional view showing an injection device according to an embodiment of the invention; and
Fig. 6 is a schematic block diagram showing a fuel injection system according to an embodiment of the invention.

### Description of Embodiments

Now referring to the drawings, preferred embodiments of a multi-layer piezoelectric element of the invention are described below.

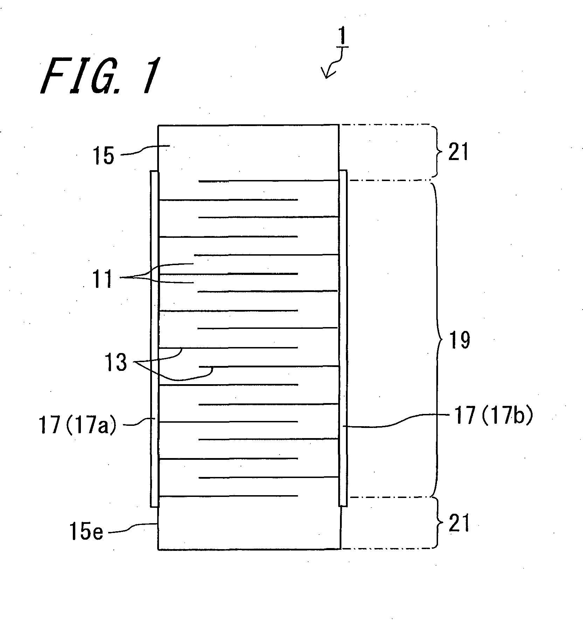

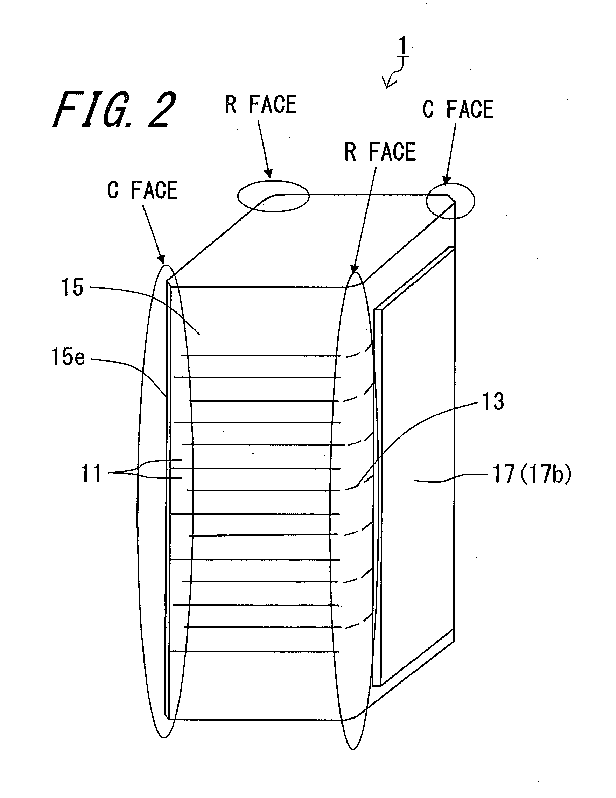

Fig. 1 is a side view showing a multi-layer piezoelectric element according to an embodiment of the invention, and Fig. 2 is a perspective view of the multi-layer piezoelectric element shown in Fig. 1.

The multi-layer piezoelectric element 1 of the present embodiment is a multi-layer piezoelectric element 1 comprising a prismatic stacked body 15 in which piezoelectric layers 11 and internal electrode layers 13 are alternately laminated, and the stacked body 15 comprises chamfered portions formed by grinding ridge portions 15e of a side peripheral surface thereof, and linear grinding traces on the chamfered portions extend in a direction along the internal electrode layers 13.

According to such a construction, since the linear grinding traces are formed along the internal electrode layers 13 on the ridge portions (edge portions) 15e of the prismatic stacked body 15, even if the linear grinding traces grow as cracks due to stress from continuous drive of the multi-layer piezoelectric element 1, the cracks do not join adjacent internal electrode layers 13 together. As a result, since short-circuiting between adjacent internal electrode layers 13 in the edge portions 15e can be effectively suppressed, durability can be improved.

In the multi-layer piezoelectric element 1, side faces which are flat faces of the side peripheral surface of the stacked body 15 are formed with a pair of external electrodes 17 (an external electrodes 17a as a negative electrode and an external electrodes 17b as a positive electrode). The stacked body 15 includes a facing portion 19 in which the internal electrode layers 13 face each other, and non-facing portions 21 located at both ends of the facing portion 19 in the laminating direction. The facing portion 19 is an active portion in which the piezoelectric layers 11 expand and contract in the laminating direction, and the non-facing portions 21 are inactive portions in which the piezoelectric layers 11 do not expand and contract in the laminating direction. That is, the non-facing portions 21 are portions in which the internal electrode layers 13 which contribute to drive during voltage application do not face each other, and are portions (inactive portions) which are not themselves driven. A metal layer or the like may be included in the non-facing portions 21.

The piezoelectric layers 11 are made of piezoelectric ceramics or the like made mainly of lead zirconate titanate (PbZrO₃-PbTiO₃), and has a thickness of about 30 to 200 µm. Additionally, the internal electrode layers 13 are made of a baked body or the like of metal powder such as silver-palladium, and have a thickness of about 1 to 5 µm.

The external electrodes 17 are made of a baked body or the like of silver powder and glass powder, and have a thickness of about 10 to 50 µm.

The average depth, length, and width of the linear grinding traces depend on grinding conditions such as the rotation speed of a stacked body and a grinding tool, the grinding pressure of the grinding tool, and the material of the stacked body and grinding tool. It is preferable that the depth is about 2 µm to 5 µm, the length is continuous in substantially the circumferential direction, and the width is about 10 µm to 50 µm, however the invention is not particularly limited thereto. Additionally, although the linear grinding traces formed on the chamfered portions extend in the direction along the internal electrode layers 13 in the side peripheral surface of the stacked body 15, it is preferable that the linear grinding traces are parallel to the planar direction of the principal surfaces of the internal electrode layers 13. In this case, generation of cracks which join adjacent internal electrode layers 13 together can be more effectively suppressed. Additionally, the linear grinding traces formed on the chamfered portions may not be completely parallel to the planar direction of the principal surfaces of the internal electrode layers 13, but may be formed at an angle of about 30° or less with respect to the planar direction of the principal surfaces of the internal electrode layers 13. In this case, generation of cracks which join adjacent internal electrode layers 13 together can be suppressed so that the cracks are not substantially generated.

According to the multi-layer piezoelectric element 1 of the present embodiment, when the stacked body 15 is formed so that the linear grinding traces extend in the direction along the internal electrode layers 13 from the chamfered portions to the flat faces of the side peripheral surface adjacent thereto, short-circuiting between adjacent internal electrode layers 13 can be effectively suppressed even in the flat faces as well as the edge portions 15e, and thereby, durability can be further improved. Of course, even in the flat faces (side faces) of the side peripheral surface of the stacked body 15, it is preferable that the linear grinding traces are formed so as to extend in the direction along the internal electrode layers 13.

In addition, the linear grinding traces may go around the side peripheral surface of the stacked body 15 continuously, and may be broken on the way. Additionally, even in that case, it is preferable that the linear grinding traces are formed so as to extend in the direction along the internal electrode layers 13 in the side peripheral surface of the stacked body 15.

Additionally, the ridge portions (edge portions) 15e of the prismatic stacked body 15 are places where cracks by stress are generated in the linear grinding traces and grow easily by continuous drive of the multi-layer piezoelectric element 1, compared to the flat faces of the side peripheral surface of the stacked body 15. Therefore, it is preferable that the parallelism of the linear grinding traces on the ridge portions (edge portions) 15e of the stacked body 15 with respect to the internal electrode layers 13 is higher than the parallelism of the linear grinding traces on the flat faces of the side peripheral surface of the stacked body 15 with respect to the internal electrode layers 13, i.e., that the linear grinding traces on the ridge portions 15e of the stacked body 15 is more parallel than the linear grinding traces on the flat faces of the side peripheral surface of the stacked body 15.

Additionally, the ridge portions (edge portions) 15e of the prismatic stacked body 15 are places where cracks due to stress are generated in the linear grinding traces and grow easily by continuous drive of the multi-layer piezoelectric element 1, compared to the flat faces of the side peripheral surface of the stacked body 15. Therefore, it is preferable that the depth of the linear grinding traces on the ridge portions (edge portions) 15e of the stacked body 15 is smaller than the depth of the linear grinding traces on the flat faces of the side peripheral surface of the stacked body 15.

Additionally, in the multi-layer piezoelectric element 1 of the present embodiment, preferably, a surface roughness of the chamfered portion and a surface roughness of the flat face of the side peripheral surface of the stacked body 15 are equal to each other. Therefore, the surface roughness of the internal electrode layers 13 is almost the same on any portion, and concentration of a local electric field in the internal electrode layers 13 is eliminated. Thus, it is possible to suppress concentration of stress in some of the internal electrode layers 13. As a result, short-circuiting between adjacent internal electrode layers 13 can be effectively suppressed in any portion of the side peripheral surface of the stacked body 15, and durability can be further improved.

The surface roughness (arithmetic average roughness Ra) of the flat faces and the surface roughness (arithmetic average roughness Ra) of the chamfered portions in the side peripheral surface of the stacked body 15 may not be completely equal to each other, and may be different from each other by about ±20%. Specifically, the surface roughness (arithmetic average roughness Ra) of the chamfered portions and the surface roughness (arithmetic average roughness Ra) of the flat faces in the side peripheral surface of the stacked body 15 are about 0.1 to 0.7 µm. The stacked body 15 having such surface roughness can be prepared by using a grinding tool which can be brought close to or separated from an object to be ground along the shape of the object as the stacked body 15 is ground by a method using a grinding tool which is installed so as to be capable of advancing and retreating with respect to the side peripheral surface of the stacked body 15 which rotates so as to grind an entire periphery of the side peripheral surface of the stacked body 15, as in the method for manufacturing a multi-layer piezoelectric element 1 of the present embodiment.

The method for manufacturing a multi-layer piezoelectric element 1 of the present embodiment is a method for manufacturing a multi-layer piezoelectric element 1 comprising the prismatic stacked body 15 in which the piezoelectric layers 11 and the internal electrode layers 13 are alternately laminated, and the method comprises grinding the side peripheral surface of the stacked body 15 by the grinding tool while rotating the stacked body 15 around a longitudinal axis thereof with holding both ends of the stacked body 15.

Through such a construction, the side peripheral surface of the stacked body 15 can be formed with the linear grinding traces extending in the direction along the internal electrode layers 13. As a result, since short-circuiting between the adjacent internal electrode layers 13 in the edge portions 15e of the stacked body 15 can be effectively suppressed, and the multi-layer piezoelectric element 1 with improved durability can be manufactured.

Additionally, in the method for manufacturing a multi-layer piezoelectric element 1 of the present embodiment, preferably, the grinding tool is installed to be capable of advancing and retreating with respect to the side peripheral surface of the stacked body 15 rotated, so as to grind the entire periphery of the side peripheral surface of the stacked body 15.

Through such a construction, the linear grinding traces extending in the direction along the internal electrode layers 13 can be formed with almost the same depth in any portion of the side peripheral surface of the stacked body 15. As a result, since short-circuiting between adjacent internal electrode layers 13 in the side peripheral surface of the stacked body 15 can be effectively suppressed, and the multi-layer piezoelectric element 1 with further improved durability can be manufactured.

Next, an example of the method for manufacturing a multi-layer piezoelectric element 1 according to an embodiment of the invention will be specifically described.

First, ceramic green sheets which become the piezoelectric layers 11 are fabricated. Specifically, calcined powder of piezoelectric ceramics, a binder made of organic polymers, such as acrylics or butyrals, and a plasticizer are mixed together to prepare slurry. Also, from this slurry, a ceramic green sheet is prepared by using well-known tape molding methods such as a doctor blade method and a calender roll method. As the piezoelectric ceramics, those having piezoelectric characteristics may be adopted. For example, a perovskite-type oxide made of PbZrO₃-PbTiO₃ or the like can be used. Additionally, DBP (dibutyl phthalate), DOP (dioctyl phthalate), or the like can be used as the plasticizer.

Next, a conductive paste which becomes the internal electrode layers 13 is prepared. Specifically, the conductive paste can be prepared by adding and mixing a binder, a plasticizer, and the like to metal powder, such as silver-palladium (Ag-Pd). This conductive paste is printed in a predetermined pattern on the above ceramic green sheet, using the screen printing method. Moreover, a plurality of ceramic green sheets on which this conductive paste has been screen-printed are laminated. Then, a stacked body 15 including the piezoelectric layers 11 and the internal electrode layers 13 which have been alternately laminated can be formed by firing.

At this time, a non-fired laminated compact is obtained by laminating and drying the ceramic green sheets on which the conductive paste has been printed. A plurality of ceramic green sheets on which the conductive paste is not printed are laminated at both ends of this non-fired laminated compact in the laminating direction, whereby these portions become the non-facing portions 21 in the stacked body 15 after firing. The non-fired laminated compact can be cut up into a desired form if needed. Subsequently, after the laminated compact has been subjected to binder removing treatment at a predetermined temperature, the laminated compact is fired at 900°C to 1150°C. Thereby, the stacked body 15 is obtained.

In addition, the stacked body 15 may be formed with a plurality of to-be-broken layers instead of some internal electrode layers 13. A plurality of piezoelectric layers 11 and internal electrode layers 13 are formed between adjacent to-be-broken layers in a sandwiched manner. For example, porous layers including a number of independent metal particles are formed as the to-be-broken layers. In order to form these porous layers, for example, there are provided a method of causing carbon powder to be contained in the conductive paste, thereby causing the carbon powder to disappear during firing, a method of performing pattern printing so as to create a dot pattern during the printing of the conductive paste, and a method of performing a dry ice blast to roughen the printing surface after the conductive paste is printed and dried.

Additionally, it is also possible to adopt a method of changing the metal component ratio of the conductive paste of the to-be-broken layers which become the porous layers and the conductive paste of the internal electrode layers 13 and diffusing metal from the to-be-broken layers during firing using the concentration difference between metal components, thereby obtaining porosity. Particularly when the silver concentration of the to-be-broken layers which become the porous layers is made higher than the silver concentration of the internal electrode layers 13, using conductive paste made mainly of silver-palladium, since silver can form a liquid phase during firing and can easily move between the piezoelectric particles of the piezoelectric layers 11, it is possible to form extremely uniform porous layers, which is preferable.

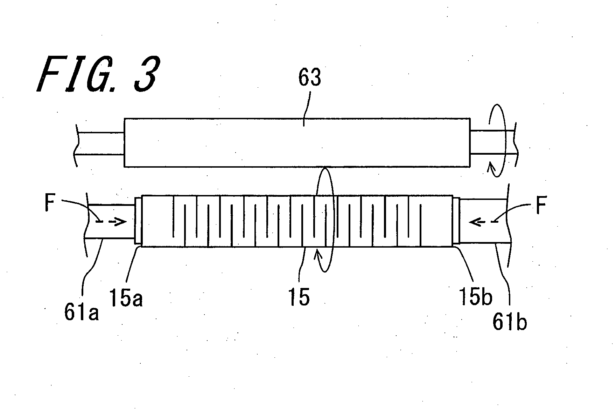

Next, the side peripheral surface of the stacked body 15 is ground. Fig. 3 is a schematic side view showing a grinding step. As shown in Fig. 3, both end faces 15a and 15b of the stacked body 15 are pressed and held by holding tools 61a and 61b, respectively. At this time, both end faces 15a and 15b of the stacked body 15 are pressurized toward the central portion of the stacked body 15. In this situation, the side peripheral surface of the stacked body 15 is ground by a grinding tool (grinding stone 63) while the stacked body 15 is rotated around the longitudinal axis thereof.

One of a plurality of side faces in the stacked body 15 is ground while the grinding stone 63 comes into contact therewith. When the grinding of one side face is completed, the rotational angle of the stacked body 15 itself is gradually changed, a ridge portion 15e of the side peripheral surface of the stacked body are processed into a C or R face, and grinding processing of another side face is performed. Similarly, this work is performed on all the side faces and ridge portions 15e. Thus, in the overall side peripheral surface, linear grinding traces can be formed so as to extend in the direction along the internal electrode layers 13.

The shape of the grinding stone 63 is a columnar shape such as a cylindrical shape, with almost the same length as the stacked body 15. However, the shape of the grinding stone is not limited to the columnar shape, and may be shapes such as a disk shape, or a cylindrical shape shorter than the stacked body 15, or a spherical shape.

When both end faces 15a and 15b of the stacked body 15 are held by applying pressure with a pressing force F of 10 MPa or more and 100 MPa or less using the holding tools 61a and 61b of which a Vickers hardness Hv is 20 or more and 100 or less, the Vickers hardness Hv of the holding tools 61a and 61b is not too high. Therefore, when the holding tools 61a and 61b hold the stacked body 15, the contact surfaces of the holding tools 61a and 61b with both end faces 15a and 15b of the stacked body 15 are pressed against the stacked body 15, and thereby deformed so as to fit both end faces 15a and 15b of the stacked body 15. Accordingly, since a large frictional force is generated between the holding tools 61a and 61b and both end faces 15a and 15b of the stacked body 15 compared to a case where the Vickers hardness Hv of the holding tools 61a and 61b is too high, the stacked body 15 can be held by the holding tools 61a and 61b by a larger force. Accordingly, it is possible to suppress reduction of grinding precision due to deviation of the stacked body 15 from the holding tools 61a and 61b during grinding.

Additionally, since the stacked body 15 is held by applying pressure with a pressing force of 10 MPa or more and 100 MPa or less, the stacked body 15 contracts in the longitudinal direction during grinding processing, it is possible to suppress deformation of the stacked body 15 in a direction orthogonal to the longitudinal direction. Accordingly, in a case where grinding resistance, the pressure caused by a grinding liquid, or the like has acted on the stacked body 15 from a direction in which the grinding stone 63 is present, it is possible to suppress deformation of the stacked body 15 in a direction in which the stacked body 15 escapes from the grinding stone 63 among directions orthogonal to the longitudinal direction. Accordingly, it is possible to suppress non-uniform grinding between the central portion of the stacked body 15 deforming in a direction in which the stacked body escapes from the grinding stone 63, and both ends of the stacked body 15 which do not deform. As a result, the side faces of the stacked body 15 can be equally ground without bias to a certain portion.

In addition, since the stacked body 15 is rotating during grinding, it is considered that, even if the stacked body 15 has deformed in a direction in which the stacked body escapes from the grinding stone 63, this deformed portion is ground by coming into contact with the grinding stone 63. However, since the stacked body 15 is formed of a number of layers in practice, the stacked body is almost in the same state as having a number of strands. Accordingly, since the rigidity of the stacked body 15 is not high, when the stacked body is pressed and held with an insufficient pressing force F, a phenomenon may always occur where the stacked body rotates in the state of having deformed in the direction in which the stacked body escapes from the grinding stone 63 in a case where grinding resistance, the pressure caused by a grinding liquid, or the like has acted on the stacked body 15 from the grinding stone 63 side. On the other hand, in case where the pressing force F is too high, the stacked body 15 is ground in a state where the central portion of the stacked body 15 which is pressed is made thicker than both ends, the amount of grinding in the central portion becomes relatively larger. Thus, a phenomenon may occur where, when the pressing force F is released after processing, the stacked body 15 in which the central portion is thinner than both ends is produced.

On the other hand, the pressing force F is set to 10 MPa or more and 100 MPa or less, so that the stacked body 15 can be held with a sufficient pressing force F without deforming the stacked body 15. Thus, it is possible to suppress reduction of grinding precision due to deviation of the stacked body 15 from the holding tools 61a and 61b or due to occurrence of bias in the amount of grinding when the stacked body 15 is ground.

The material of the grinding stone 63 includes diamond or the like, and the rotation speed of the grinding stone is about 2000 to 8000 rpm. The stacked body 15 also rotates in the same rotational direction as the grinding stone 63, and the rotation speed thereof is about 80 to 150 rpm.

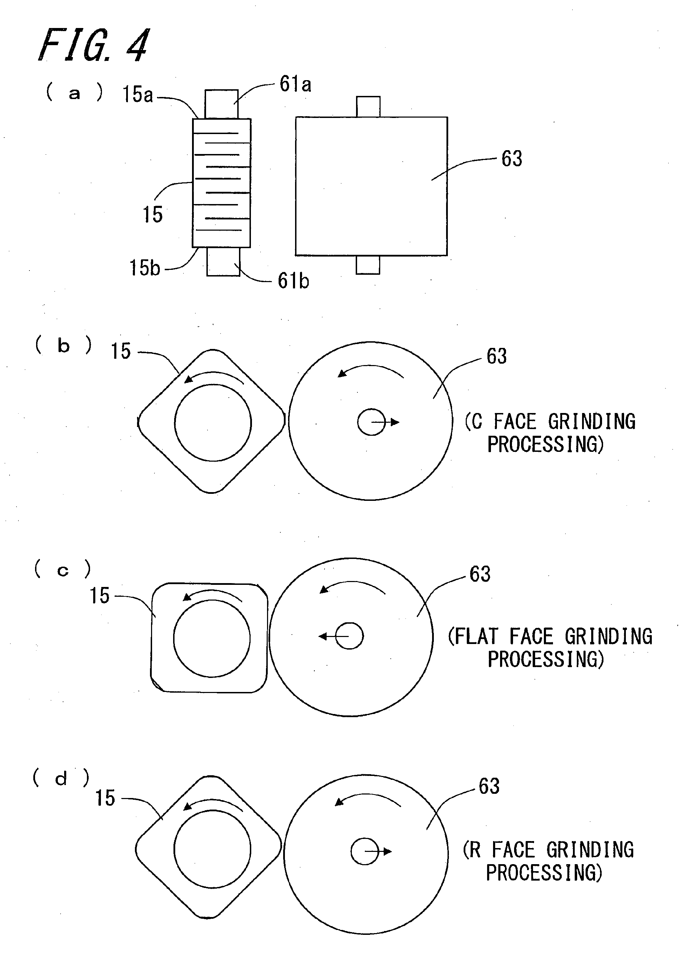

Figs. 4(a) to 4(d) show individual grinding steps in the method for manufacturing a multi-layer piezoelectric element according to another embodiment of the invention. In this embodiment, the grinding stone 63 which is a grinding tool is installed so as to be capable of advancing and retreating with respect to the side peripheral surface of the rotating stacked body 15 so as to grind the entire periphery of the side peripheral surface of the stacked body 15. That is, a rotating shaft of the cylindrical grinding stone 63 is adapted to be capable of advancing and retreating with respect to the side peripheral surface of the rotating stacked body 15. A mechanism in which the rotating shaft of such a cylindrical grinding stone 63 is capable of advancing and retreating can be realized by means of installing a motor or the like connected to the rotating shaft so as to be movable in a direction orthogonal to the rotating shaft. Additionally, the motor connected to the rotating shaft is made movable in the direction orthogonal to the rotating shaft so that the grinding pressure may become almost constant or the grinding pressure follows a predetermined change curve by detecting the force (grinding pressure) applied to the rotating shaft from the stacked body 15 by a pressure sensor or a torque meter attached to the motor, and controlling the grinding pressure by a computer program.

Additionally, in order to form a constant depth of grinding traces at the entire periphery of the side peripheral surface of the stacked body 15, the following may be performed.

In a state where a stacked body 15 is made stationary without being rotated, only the grinding stone 63 is rotated to grind the side peripheral surface of the stacked body 15. Additionally, the rotating shaft of the grinding stone 63 is made movable around an axis in the direction of a long side of the stacked body 15. Accordingly, since the grinding stone 63 itself is rotating and moving around the axis in the direction of the long side of the stacked body 15, the entire periphery of the side peripheral surface of the stacked body 15 can be ground. In addition, in a case where the rotating shaft of the grinding stone 63 is moved around the axis in the direction of the long side of the stacked body 15, control may be performed by a program in advance in consideration of the radius of the grinding stone 63 so that the rotating shaft of the grinding stone 63 is moved in accordance to the cross-sectional shape of the stacked body 15. For example, in a case where the rotating shaft of the grinding stone 63 has been made to move along a rectangular peripheral edge portion having a size several times the size of the cross-sectional shape of the stacked body 15, since a constant depth of grinding traces can be formed over the entire periphery of the side peripheral surface of the stacked body 15, this is preferable.

Additionally, by keeping the grinding pressure constant, as mentioned above, the linear grinding traces extending in the direction along the internal electrode layers 13 can be formed with almost the same depth, in any portion of the side peripheral surface of the stacked body 15. As a result, short-circuiting between adjacent internal electrode layers 13 in the side peripheral surface of the stacked body 15 can be effectively suppressed.

Additionally, in order to perform grinding with a constant pressure in any portion of the side peripheral surface of the stacked body 15 by the grinding stone 63, it is preferable that the rotation speed of the grinding stone 63 is about 2000 to 8000 rpm, and the rotation speed of the stacked body 15 is about 80 to 150 rpm. Additionally, it is preferable that the diameter of the grinding stone 63 is about 200 to 400 mm.

As shown in a plan view of Fig. 4(a), both end faces 15a and 15b of the stacked body 15 are held by the holding tools 61a and 61b, respectively.

Fig. 4(b) shows a longitudinal cross-sectional view showing a state where an edge portion 15e of the stacked body 15 is processed into a C face by the grinding stone 63 in a state where the stacked body 15 is pressed by the holding tools 61a and 61b. In accordance with the protruding of the ridge portion 15e of the stacked body 15 toward the grinding stone 63, the grinding stone 63 retreats and performs C face processing.

Fig. 4(c) is a longitudinal cross-sectional view showing a state where a flat face which is a side face of the stacked body 15 is ground. In accordance with the retracting of the flat face of the stacked body 15 toward the side opposite to the grinding stone 63, the grinding stone 63 advances and performs grinding processing.

Fig. 4(d) shows a longitudinal cross-sectional view showing a state where an edge portion 15e of the stacked body 15 is processed into an R face by the grinding stone 63 in a state where the stacked body 15 is pressed by the holding tools 61a and 61b. In accordance with the protruding of the ridge portion 15e of the stacked body 15 toward the grinding stone 63, the grinding stone 63 retreats and performs R face processing.

The stacked body 15 with a predetermined shape is prepared by repeating the operations shown in Figs. 4(b) to 4(d). Then, the linear grinding traces extending in the direction along the internal electrode layers 13 are formed on the whole surface of the side peripheral surface of the stacked body 15.

Thereafter, the external electrodes 17 are formed on the external surface of the stacked body 15 of the multi-layer piezoelectric element 1 so that conduction with the internal electrode layers 13 of which the ends are to be exposed are obtained. These external electrodes 17 can be obtained by adding a binder to a silver powder and a glass powder to prepare a silver glass conductive paste, and printing this paste on the side faces of the stacked body 15 and drying and bonding the paste, or baking the paste at 600 to 800°C.

Moreover, the external surfaces of the external electrodes 17 may be formed with a conductive auxiliary member (not shown) made of a conductive adhesive in which a metal mesh or a mesh-like metal plate is buried. The metal mesh is a member knitted by a metal wire, and the mesh-like metal plate is a member in which holes are formed in the shape of a mesh in a metal plate.

Next, the stacked body 15 in which the external electrodes 17 have been formed is immersed in a resin solution including sheathing resin made of silicone rubber. Then, by vacuum-deaerating the silicone resin solution, the silicone resin is brought into close contact with concavo-convex portions of the side peripheral surface of the stacked body 15, and thereafter, the stacked body 15 is pulled up from the silicone resin solution. Thus, the silicone resin (not shown) is coated on the side faces of the stacked body 15. Then, lead wires (not shown) serving as power feeding portions are connected to the external electrodes 17 with a conductive adhesive (not shown) or the like.

Next, a direct-current electric field of 0.1 to 3 kV/mm is applied to the piezoelectric layers 11 by the internal electrode layers 13 from the pair of external electrodes 17 via lead wires, and the multi-layer piezoelectric element 1 is completed by polarizing the piezoelectric layers 11 of the stacked body 15.

Also, the individual piezoelectric layers 11 can be greatly displaced by an inverse piezoelectric effect by connecting the lead wires to an external voltage supply part (not shown), and applying a voltage to the piezoelectric layers 11 by the internal electrode layers 13 via the lead wires and the external electrodes 17. Thus, for example, it is possible to make the multi-layer piezoelectric element function as a fuel injection valve mechanism for an automobile which injects and supplies fuel to an engine.

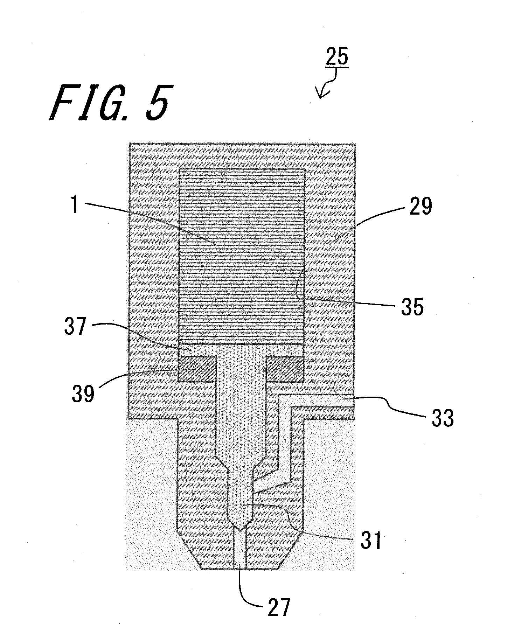

Fig. 5 is a schematic cross-sectional view showing an injection device according to an embodiment of the invention. As shown in Fig. 5, in the injection device 25, the multi-layer piezoelectric element 1 of the above embodiment is housed inside a housing container 29 which has an injection nozzle 27 at its one end. A needle valve 31 capable of opening and closing the injection nozzle 27 is disposed within the housing container 29. A fuel passage 33 is disposed in the injection nozzle 27 so as to be capable of communicating with the injection nozzle according to the movement of the needle valve 31. The fuel passage 33 is connected to an external fuel supply source from which fuel is supplied to the fuel passage 33 always at a constant high pressure. Accordingly, when the needle valve 31 opens the injection nozzle 27, the fuel which has been supplied to the fuel passage 33 is injected into a fuel chamber of an internal combustion engine (not shown) at a constant high pressure.

Additionally, the upper end of a needle valve 31 has a larger internal diameter, and has arranged therein a piston 37 slidable on a cylinder 35 formed in the housing container 29. Then, a piezoelectric actuator including the multi-layer piezoelectric element 1 of the above embodiment is housed in the housing container 29.

In such an injection device 25, when a voltage is applied to the piezoelectric actuator, and the piezoelectric actuator expands, the piston 37 is pressed, and the needle valve 31 blocks the injection nozzle 27 to stop the supply of fuel. Additionally, when the application of a voltage is stopped, the piezoelectric actuator contracts, the dish spring 39 pushes back the piston 37, the injection nozzle 27 communicates with the fuel passage 33, thereby performing injection of fuel.

Additionally, the injection device 25 of the present embodiment includes a container having the injection nozzle 27, and the multi-layer piezoelectric element 1 of the above embodiment, and may be constructed so that a liquid stored in the container is configured to be injected through the injection nozzle 27 by driving the multi-layer piezoelectric element 1. That is, the multi-layer piezoelectric element 1 is not necessarily inside the container, and may be constructed so that a pressure is applied to the inside of the container by driving the multi-layer piezoelectric element 1. In addition, various liquid fluids (conductive paste or the like) other than fuel or ink are included in the liquid.

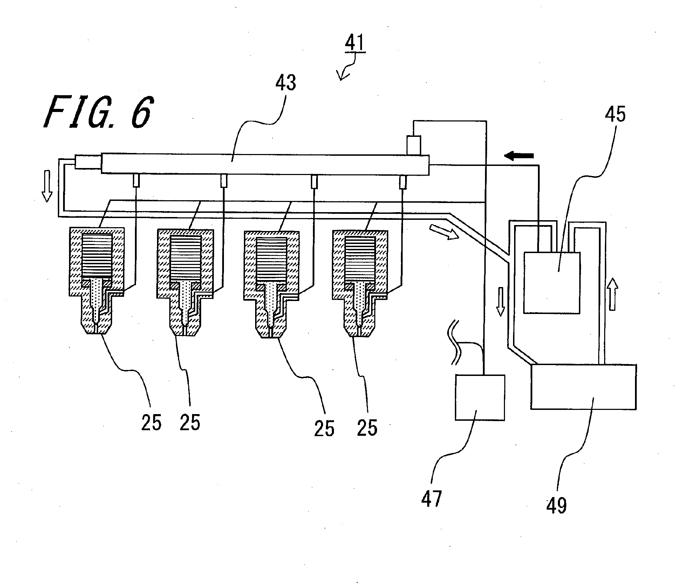

Fig. 6 is a schematic block diagram showing a fuel injection system according to an embodiment of the invention. As shown in Fig. 6, the fuel injection system 41 of the present embodiment includes a common rail 43 configured to store high-pressure fuel, a plurality of the injection devices 25 of the above embodiment configured to inject the fuel stored in the common rail 43, a pressure pump 45 configured to supply the high-pressure fuel to the common rail 43, and an injection control unit 47 configured to send a driving signal to the injection device 25.

The injection control unit 47 controls the amount and timing of fuel injection while sensing the situation of the combustion chamber of the engine by a sensor or the like. The pressure pump 45 plays the role of feeding fuel into the common rail 43 from the fuel tank 49 at about 1000 to 2000 atmospheres, and preferably at about 1500 to 1700 atmospheres. In the common rail 43, the fuel sent from the pressure pump 45 is stored and appropriately fed into the injection device 25. The injection device 25 injects a small amount of fuel in the form of a mist into the internal combustion chamber from the injection nozzle 27 as described above.

In addition, the invention is not limited to the above embodiment, and it is perfectly acceptable that various changes are made without departing from the concept of the invention. For example, the multi-layer piezoelectric element of the invention can be applied to a printing device of as an ink jet printer, or a pressure sensor, and arbitrary multi-layer piezoelectric elements using piezoelectric characteristics can be carried out with the same construction.

### Reference Signs List

1: Multi-layer piezoelectric element
11: Piezoelectric layer
13: Internal electrode layer
15: Stacked body
15a, 15b: Both end faces
15e: Ridge Portion (edge portion)
17: External electrode
61a, 61b: Holding tool
63: Grinding stone (grinding tool)

## Claims

1. A multi-layer piezoelectric element (1), comprising:
a prismatic stacked body (15) in which piezoelectric layers (11) and internal electrode layers (13) are alternately laminated, wherein
the stacked body (15) comprises a chamfered portion formed by grinding a ridge portion (15e) of a side peripheral surface thereof,
**characterized in that** a linear grinding trace on the chamfered portion extends in a direction along the internal electrode layers (13), and
the stacked body (15) is formed so that the linear grinding trace extends in the direction along the internal electrode layers (13) from the chamfered portion to a flat face of a side peripheral surface adjacent thereto.

2. The multi-layer piezoelectric element (1) according to claim 1, wherein a surface roughness of the chamfered portion and a surface roughness of the flat face of the side peripheral surface in the stacked body (15) are equal to each other.

3. A method for manufacturing a multi-layer piezoelectric element (1) which comprises a prismatic stacked body (15) in which piezoelectric layers (11) and internal electrode layers (13) are alternately laminated, the method comprising:
grinding a side peripheral surface of the stacked body (15) by a grinding tool (63) while rotating the stacked body (15) around a longitudinal axis thereof with holding both ends of the stacked body (15).

4. The method according to claim 3, wherein the grinding tool (63) is installed to be capable of advancing and retreating with respect to the side peripheral surface of the stacked body (15) rotated, so as to grind an entire periphery of the side peripheral surface of the stacked body (15).

5. The method according to claim 3 or 4, wherein both end faces of the stacked body (15) are held by applying pressure with a pressing force of 10 MPa or more and 100 MPa or less using a holding tool (61a, 61b) of which a Vickers hardness Hv is 20 or more and 100 or less.

6. An injection device (25), comprising:
a container (29) comprising an injection nozzle (27); and
the multi-layer piezoelectric element (1) according to claim 1 or 2,
wherein a liquid stored in the container (29) is configured to be injected through the injection nozzle (27) by driving the multi-layer piezoelectric element (1).

7. A fuel injection system (41), comprising:
a common rail (43) configured to store high-pressure fuel;
the injection device (25) according to claim 6 configured to inject the high-pressure fuel stored in the common rail (43);
a pressure pump (45) configured to supply the high-pressure fuel to the common rail (43); and
an injection control unit (47) configured to send a driving signal to the injection device (25).

## Patentansprüche

1. Mehrschichtiges piezoelektrisches Element (1), mit einem quaderförmigen Stapelkörper (15), in dem piezoelektrische Schichten (11) und innere Elektrodenschichten (13) abwechselnd geschichtet sind, wobei
der Stapelkörper (15) einen abgeschrägten Bereich aufweist, der durch Schleifen eines Kantenbereichs (15e) einer Seitenumfangsfläche des Körpers hergestellt ist,
**dadurch gekennzeichnet, dass** eine geradlinige Schleifspur auf dem abgeschrägten Bereich sich in einer Richtung entlang der inneren Elektrodenschichten (13) erstreckt, und dass der Stapelkörper (15) so geformt ist, dass sich die geradlinige Schleifspur in der Richtung entlang der inneren Elektrodenschichten (13) von dem abgeschrägten Bereich bis zu einer flachen Seite der seitlichen Umfangsfläche, die dazu benachbart ist, erstreckt.

2. Mehrschichtiges piezoelektrisches Element (1) nach Anspruch 1, wobei eine Oberflächenrauhigkeit des abgeschrägten Bereichs und eine Oberflächenrauhigkeit der flachen Seite der seitlichen Umfangsfläche in dem Stapelkörper (15) gleich zueinander sind.

3. Verfahren zur Herstellung eines mehrschichtigen piezoelektrischen Elements (1), welches einen quaderförmigen Stapelkörper (15) aufweist, in dem piezoelektrische Schichten (11) und innere Elektrodenschichten (13) abwechselnd zueinander geschichtet sind, wobei das Verfahren aufweist:
Schleifen einer Seitenumfangsfläche des Stapelkörpers (15) mit einem Schleifwerkzeug (63), während der Stapelkörper (15) um eine Längsachse des Stapelkörpers gedreht wird, wobei beide Enden des Stapelkörpers (15) gehaltert werden.

4. Verfahren nach Anspruch 3, wobei das Schleifwerkzeug (63) so installiert ist, dass es bezüglich der Seitenumfangsfläche des gedrehten Stapelkörpers (15) nach vorne und zurück bewegt werden kann, um eine gesamte Umfangsfläche der seitlichen Umfangsfläche des Stapelkörpers (15) zu schleifen.

5. Verfahren nach Anspruch 3 oder 4, wobei beide Endflächen des Stapelkörpers (15) gehaltert werden durch Anlegen eines Drucks mit einer Presskraft von 10 MPa oder mehr, und 100 MPa oder weniger, unter Verwendung eines Haltewerkzeugs (61a, 61b), dessen Vickers-Härte Hv 20 oder mehr, und 100 oder weniger, beträgt.

6. Einspritzvorrichtung (25) mit:
einem Behälter (29), der eine Einspritzdüse (27) aufweist, und
dem mehrschichtigen piezoelektrischen Element (1) nach Anspruch 1 oder 2,
wobei eine in dem Behälter (29) gelagerte Flüssigkeit so konfiguriert ist, dass sie durch die Einspritzdüse (27) eingespritzt wird, indem das mehrschichtige piezoelektrische Element (1) betätigt wird.

7. Kraftstoffeinspritzsystem (41) mit:
einer Common-Rail-Einspritzung (43), die konfiguriert ist, um Kraftstoff unter hohem Druck zu speichern,
der Einspritzvorrichtung (25) gemäß Anspruch 6, die so konfiguriert ist, dass sie den Hochdruck-Kraftstoff, der in der Common-Rail-Einspritzung (43) gespeichert ist, einspritzt,
einer Druckpumpe (45), die konfiguriert ist, um die Common-Rail-Einspritzung (43) mit Hochdruck-Kraftstoff zu speisen, und
einer Einspritzsteuereinheit (47), die konfiguriert ist, um ein Steuersignal an die Einspritzvorrichtung (25) zu senden.

## Revendications

1. Élément (1) piézoélectrique multicouche, comprenant :
un corps (15) empilé prismatique dans lequel des couches (11) piézoélectriques et des couches (13) d'électrodes internes sont stratifiées de façon alternée, dans lequel
le corps (15) empilé comprend une partie chanfreinée formée par meulage d'une partie (15e) d'arête d'une surface périphérique latérale de celui-ci,
**caractérisé en ce qu'**une trace de meulage linéaire sur la partie chanfreinée s'étend dans un sens le long des couches (13) d'électrodes internes, et
le corps (15) empilé est formé de telle façon que la trace de meulage linéaire s'étend dans le sens le long des couches (13) d'électrodes internes de la partie chanfreinée jusqu'à une face plate d'une surface périphérique latérale adjacente à celle-ci.

2. Élément (1) piézoélectrique multicouche selon la revendication 1, dans lequel une rugosité de surface de la partie chanfreinée et une rugosité de surface de la face plate de la surface périphérique latérale dans le corps (15) empilé sont égales l'une à l'autre.

3. Procédé de fabrication d'un élément (1) piézoélectrique multicouche qui comprend un corps (15) empilé prismatique dans lequel des couches (11) piézoélectriques et des couches (13) d'électrodes internes sont stratifiées de façon alternée, le procédé comprenant :
le meulage d'une surface périphérique latérale du corps (15) empilé par un outil (63) de meulage tout en faisant tourner le corps (15) empilé autour d'un axe longitudinal de celui-ci avec un maintien des deux extrémités du corps (15) empilé.

4. Procédé selon la revendication 3, dans lequel l'outil (63) de meulage est installé de façon à être apte à avancer et se retirer par rapport à la surface périphérique latérale du corps (15) empilé mis en rotation, de façon à meuler la totalité d'une périphérie de la surface périphérique latérale du corps (15) empilé.

5. Procédé selon la revendication 3 ou 4, dans lequel les deux faces d'extrémité du corps (15) empilé sont maintenues en appliquant une pression avec une force de pression de 10 MPa ou plus et 100 MPa ou moins en utilisant un outil (61a, 61 b) de maintien dont une dureté de Vickers Hv est 20 ou plus et 100 ou moins.

6. Dispositif (25) d'injection, comprenant :
un récipient (29) comprenant une buse (27) d'injection ; et
l'élément (1) piézoélectrique multicouche selon la revendication 1 ou 2,
dans lequel un liquide stocké dans le récipient (29) est configuré pour être injecté à travers la buse (21) d'injection par pilotage de l'élément (1) piézoélectrique multicouche.

7. Système (41) d'injection de carburant, comprenant :
une rampe commune (43) configurée pour stocker un carburant sous haute pression ;
le dispositif (25) d'injection selon la revendication 6 configuré pour injecter le carburant sous haute pression stocké dans la rampe commune (43) ;
une pompe (45) de pression configurée pour amener le carburant sous haute pression jusqu'à la rampe commune (43) ; et
une unité (47) de commande d'injection configurée pour envoyer un signal de pilotage au dispositif (25) d'injection.
